# EUROPEAN PATENT APPLICATION

(11) **EP 3 770 972 A1**
(43) Date of publication of application: **27.01.2021**
(21) Application number: 19187682.0
(22) Date of filing: 22.07.2019
(51) Int. Cl.: H01L 29/66, H01L 21/8234

(54) **PROTECTION OF AN INTERLAYER DIELECTRIC**

(71) Applicant: Imec VZW, 3001 Leuven (BE)
(72) Inventor: DENTONI LITTA, Eugenio, 3001 Leuven (BE); ONIKI, Yusuke, 3001 Leuven (BE); RAGNARSSON, Lars-Ake, 3001 Leuven (BE); CHAN, Boon Teik, 3001 Leuven (BE)
(74) Representative: DenK iP bv

(57) **Abstract**

In a first aspect, the present invention relates to a method for removing a dummy gate (300), comprising: (a) providing a semiconductor structure comprising: (i) a substrate (100), (ii) a dummy gate (300) on the substrate (100), (iii) a trench (400) adjoining the dummy gate (300) by a sidewall, (iv) one or more auxiliary layers (600,700) lining the sidewall, and (v) an interlayer dielectric (800) partially filling the trench (400) such that a cavity (410) at a top of the trench (400) is unfilled; (b) covering the semiconductor structure with an etch stop layer (900), thereby at least partially filling the cavity (410); (c) removing the etch stop layer (900) over the dummy gate (300) while maintaining it in the cavity (410), and (d) removing the dummy gate (300) selectively with respect to the etch stop layer (900) and the one or more auxiliary layers (600,700).

## Description

### Technical field of the invention

The present invention relates to semiconductor processing and more particularly to protecting an interlayer dielectric during a part of said processing.

### Background of the invention

In semiconductor processing, the ILD0 (0^{th} interlayer dielectric) is the dielectric whose purpose is for example to passivate the front-end-of-line (FEOL) after epitaxial growth of the source/drain, to serve as stopping level for chemical-mechanical planarization (e.g. during a replacement metal gate process), and to provide the insulation in which source/drain contacts are defined and deposited. Apart from electrical considerations, the ILD0 should also have very good gap fill capabilities (e.g. for filling the trenches between gate lines without voids or seams). This is because voids and seams can capture undesired metal residues, e.g. during the replacement metal gate (RMG) and/or contact module processes. Furthermore, the ILD0 should be removed as little as possible by the dry and wet etch steps used during the processing, since the final ILD0 height defines the final gate height.

Fin pitch and gate pitch scaling requires the use of oxide deposition techniques which are optimized for gap fill of high aspect ratio trenches without voids or seams. Such oxides are not as dense as isolations used in older technology nodes, and as a result exhibit higher wet etch rate (WER) in (HF-based) etching and cleaning steps. This is especially problematic in gate-all-around (GAA) flows, where relatively long etching steps are needed to ensure proper surface cleaning, resulting in considerable ILD0 (and thus gate) height loss during the replacement metal gate (RMG) module.

Furthermore, rather than performing gate cutting at the dummy gate stage, gate cutting of the replacement metal gate is being evaluated as a scaling booster for, for example, static random-access memory (SRAM). Such a gate cut should be highly selective to the gate spacer and ILD0, which is challenging to achieve while keeping a vertical straight profile in the etched gate.

There is thus still a need in the art for processing flows which address some or all of the issued outlined above.

### Summary of the invention

It is an object of the present invention to provide protective measures for an interlayer dielectric during semiconductor processing, such as during dummy gate removal and/or gate cutting. This objective is accomplished by methods and semiconductor structures according to the present invention.

It is an advantage of embodiments of the present invention that the interlayer dielectric can be protected from being unintentionally removed (e.g. etched).

It is an advantage of embodiments of the present invention that the interlayer dielectric may remain unexposed (e.g. an etchant may not be able to contact the interlayer dielectric) when it is to be protected.

It is an advantage of embodiments of the present invention that the height of the interlayer dielectric can be well controlled and thus that the gate height can be well controlled.

It is an advantage of embodiments of the present invention that the protective measures can be removed again at a later stage in the semiconductor processing. It is a further advantage of embodiments of the present invention that by not having the protective measures present in the final device, they do not interfere with the operation thereof.

It is an advantage of embodiments of the present invention that one can select steps of the semiconductor processing during which the interlayer dielectric is to be protected; these can, for example, include the steps of dummy gate removal and/or gate cutting. It is a further advantage of embodiments of the present invention that protective measures provided for one processing step (e.g. dummy gate removal) can double up for protecting during a second processing step (e.g. gate cutting).

It is an advantage of embodiments of the present invention that the interlayer dielectric may be free of voids or seams. It is a further advantage of embodiments of the present invention that the technique for depositing the interlayer dielectric can be selected to maximize its gap fill properties, without needing to heed the wet etch ratio of the resulting interlayer dielectric.

It is an advantage of embodiments of the present invention that they are suitable for the 7 nm technology node and beyond.

It is an advantage of embodiments of the present invention that they are compatible with both gate-all-around (GAA) and non-GAA processing flows.

It is an advantage of embodiments of the present invention that techniques and materials are used which are widely employed in semiconductor processing.

It is an advantage of embodiments of the present invention that the method can be performed in a time efficient and economical fashion.

In a first aspect, the present invention relates to a method for removing a dummy gate, comprising: (a) providing a semiconductor structure comprising: (i) a substrate, (ii) a dummy gate on the substrate, (iii) a trench adjoining the dummy gate by a sidewall, (iv) one or more auxiliary layers lining the sidewall, and (v) an interlayer dielectric partially filling the trench such that a cavity at a top of the trench is unfilled; (b) covering the semiconductor structure with an etch stop layer, thereby at least partially filling the cavity; (c) removing the etch stop layer over the dummy gate while maintaining it in the cavity, and (d) removing the dummy gate selectively with respect to the etch stop layer and the one or more auxiliary layers.

In a second aspect, the present invention relates to a method for replacing a dummy gate, comprising the method according to any of the previous claims and further comprising: (e) filling an opening, obtained by removing the dummy gate in step d, with a replacement gate.

In a third aspect, the present invention relates to a semiconductor structure, comprising: (i) a substrate, (ii) a dummy gate on the substrate, (iii) a trench adjoining the dummy gate by a sidewall, (iv) one or more auxiliary layers lining the sidewall, (v) an interlayer dielectric partially filling the trench such that a cavity at a top of the trench is unfilled, and (vi) an etch stop layer covering at least the interlayer dielectric.

Particular and preferred aspects of the invention are set out in the accompanying independent and dependent claims. Features from the dependent claims may be combined with features of the independent claims and with features of other dependent claims as appropriate and not merely as explicitly set out in the claims.

Although there has been constant improvement, change and evolution of devices in this field, the present concepts are believed to represent substantial new and novel improvements, including departures from prior practices, resulting in the provision of more efficient, stable and reliable devices of this nature.

The above and other characteristics, features and advantages of the present invention will become apparent from the following detailed description, taken in conjunction with the accompanying drawings, which illustrate, by way of example, the principles of the invention. This description is given for the sake of example only, without limiting the scope of the invention. The reference figures quoted below refer to the attached drawings.

### Brief description of the drawings

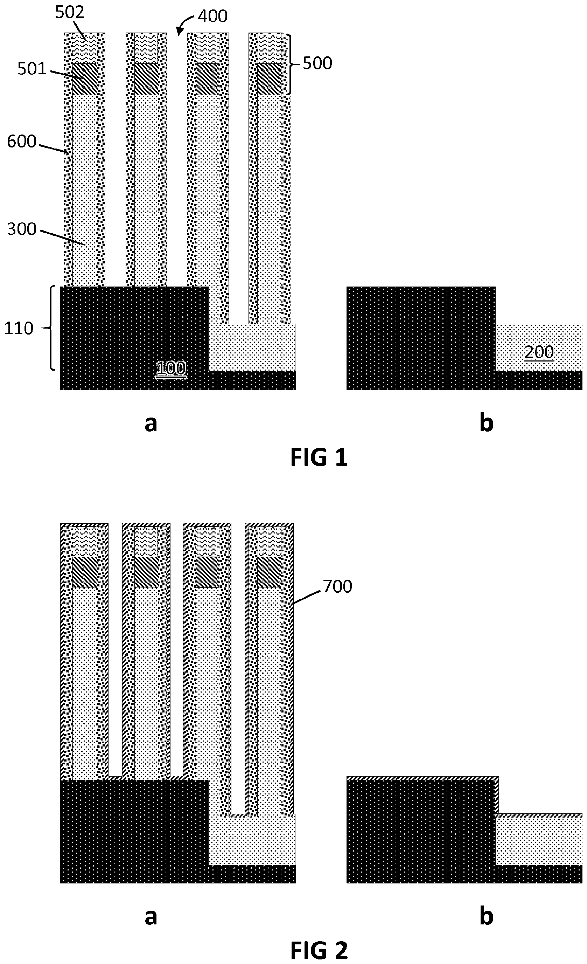

FIG 1-22 schematically depict semiconductor structures at different stages of methods in accordance with exemplary embodiments of the present invention. In each case, a dense region (a), i.e. comprising several closely spaced features such as (dummy) gates, trenches, etc., and an isolated region (b), i.e. being relatively free of these features, are depicted.

In the different figures, the same reference signs refer to the same or analogous elements.

### Description of illustrative embodiments

The present invention will be described with respect to particular embodiments and with reference to certain drawings but the invention is not limited thereto but only by the claims. The drawings described are only schematic and are non-limiting. In the drawings, the size of some of the elements may be exaggerated and not drawn on scale for illustrative purposes. The dimensions and the relative dimensions do not correspond to actual reductions to practice of the invention.

Furthermore, the terms first, second, third and the like in the description and in the claims, are used for distinguishing between similar elements and not necessarily for describing a sequence, either temporally, spatially, in ranking or in any other manner. It is to be understood that the terms so used are interchangeable under appropriate circumstances and that the embodiments of the invention described herein are capable of operation in other sequences than described or illustrated herein.

Moreover, the terms top, bottom, over, under and the like in the description and the claims are used for descriptive purposes and not necessarily for describing relative positions. It is to be understood that the terms so used are interchangeable with their antonyms under appropriate circumstances and that the embodiments of the invention described herein are capable of operation in other orientations than described or illustrated herein.

It is to be noticed that the term "comprising", used in the claims, should not be interpreted as being restricted to the means listed thereafter; it does not exclude other elements or steps. It is thus to be interpreted as specifying the presence of the stated features, integers, steps or components as referred to, but does not preclude the presence or addition of one or more other features, integers, steps or components, or groups thereof. The term "comprising" therefore covers the situation where only the stated features are present and the situation where these features and one or more other features are present. Thus, the scope of the expression "a device comprising means A and B" should not be interpreted as being limited to devices consisting only of components A and B. It means that with respect to the present invention, the only relevant components of the device are A and B.

Reference throughout this specification to "one embodiment" or "an embodiment" means that a particular feature, structure or characteristic described in connection with the embodiment is included in at least one embodiment of the present invention. Thus, appearances of the phrases "in one embodiment" or "in an embodiment" in various places throughout this specification are not necessarily all referring to the same embodiment, but may. Furthermore, the particular features, structures or characteristics may be combined in any suitable manner, as would be apparent to one of ordinary skill in the art from this disclosure, in one or more embodiments.

Similarly, it should be appreciated that in the description of exemplary embodiments of the invention, various features of the invention are sometimes grouped together in a single embodiment, figure, or description thereof for the purpose of streamlining the disclosure and aiding in the understanding of one or more of the various inventive aspects. This method of disclosure, however, is not to be interpreted as reflecting an intention that the claimed invention requires more features than are expressly recited in each claim. Rather, as the following claims reflect, inventive aspects lie in less than all features of a single foregoing disclosed embodiment. Thus, the claims following the detailed description are hereby expressly incorporated into this detailed description, with each claim standing on its own as a separate embodiment of this invention.

Furthermore, while some embodiments described herein include some but not other features included in other embodiments, combinations of features of different embodiments are meant to be within the scope of the invention, and form different embodiments, as would be understood by those in the art. For example, in the following claims, any of the claimed embodiments can be used in any combination.

In the description provided herein, numerous specific details are set forth. However, it is understood that embodiments of the invention may be practised without these specific details. In other instances, well-known methods, structures and techniques have not been shown in detail in order not to obscure an understanding of this description.

Reference will be made to transistors. These are devices having a first main electrode such as a drain, a second main electrode such as a source and a control electrode such as a gate for controlling the flow of electrical charges between the first and second main electrodes.

The following terms are provided solely to aid in the understanding of the invention.

As used herein, and unless otherwise specified, a 'dummy gate' is a non-functional gate which is typically used as a placeholder, to be replaced by a functional gate at some later stage of the semiconductor processing (e.g. during a replacement metal gate process). A 'dummy gate' may alternatively be referred to as a 'sacrificial gate'.

As used herein, and unless otherwise specified, 'gate cutting' (e.g. cutting of a replacement gate) refers to the act of completely removing one or more selected portions of a gate so as to interrupt the gate and obtain two or more separate, electrically disconnected, gates.

As used herein, and unless otherwise specified, when a first material is said to be etched selectively with respect to a second material, this means that the first material is etched faster than the second material. Preferably, the etching process would etch the first material at least twice faster, or more preferably at least five times faster, yet more preferably at least ten times faster, than the second material. In some preferred embodiments, the second material may be substantially not etched by the etching process.

In a first aspect, the present invention relates to a method for removing a dummy gate, comprising: (a) providing a semiconductor structure comprising: (i) a substrate, (ii) a dummy gate on the substrate, (iii) a trench adjoining the dummy gate by a sidewall, (iv) one or more auxiliary layers lining the sidewall, and (v) an interlayer dielectric partially filling the trench such that a cavity at a top of the trench is unfilled; (b) covering the semiconductor structure with an etch stop layer, thereby at least partially filling the cavity; (c) removing the etch stop layer over the dummy gate while maintaining it in the cavity, and (d) removing the dummy gate selectively with respect to the etch stop layer and the one or more auxiliary layers.

In embodiments, the method may be part of a semiconductor processing to form a semiconductor device (e.g. a transistor). In embodiments, the method may be for use in a 7 nm technology node or beyond semiconductor processing. Nevertheless, it will be appreciated that the method can also be beneficial in earlier technology nodes, such as the 14 nm technology node or higher.

In embodiments, the substrate may be a semiconductor substrate (e.g. a Si-on-insulator, Ge or Ge-on-insulator substrate). In embodiments, the substrate may comprise a fin. In embodiments, the dummy gate may be on the fin. In embodiments, the substrate may comprise a source region and/or a drain region. In embodiments, the trench may be present over the source or the drain region (e.g. on the source/drain region). In embodiments, the substrate may comprise a channel region defined between the source and drain region and under the replacement gate (i.e. the functional gate replacing the dummy gate).

In embodiments, the dummy gate may be part of a set of dummy gates. In embodiments, the set of dummy gates may form a set of dummy gate lines. The dummy gates in a set of dummy gate lines typically run parallel to one another. In embodiments, the dummy gate may be for forming a gate-all-around replacement gate.

Under 'a trench adjoining the dummy gate by a sidewall' is understood that the trench is adjacent to the dummy gate and is partially defined by the sidewall of the dummy gate. The trench may, for example, be defined on opposing sides between two dummy gates (e.g. two parallel dummy gates), more particularly between two sidewalls each belonging to one of the dummy gates, and at the bottom by the substrate. Note that the trench is typically not empty, as not only does the interlayer dielectric partially fill the cavity, but also one or more auxiliary layers line the sidewall (and are thus present in the cavity). In embodiments, the trench may have a width of 30 nm or less, preferably 26 nm or less.

In embodiments, the one or more auxiliary layers may comprise a gate spacer and, optionally, a gate liner. The gate liner is typically used to protect the semiconductor structure while growing the interlayer dielectric and can further serve as a contact etch stop layer. Nevertheless, particularly as device sizes further scale down, there may be a desire to omit the gate liner (provided material selection and techniques used permit doing so). In embodiments, one or more of the auxiliary layers lining the sidewall may not fully cover the substrate. In complementary or alternative embodiments, one or more of the auxiliary layers lining the sidewall may fully cover the substrate.

In embodiments, the interlayer dielectric may be an ILD0. In embodiments, the interlayer dielectric may comprise (e.g. consist of) SiO₂. In embodiments, notwithstanding the presence of the unfilled cavity at the top of the trench and the one or more auxiliary layers lining the sidewall, the interlayer dielectric may otherwise completely fill the trench from the bottom up. In embodiments, the interlayer dielectric may be free of voids or seams. In embodiments, the interlayer dielectric may have been provided using a flowable chemical vapour deposition (FCVD). FCVD advantageously has excellent gap fill capabilities and thus yields an interlayer dielectric with little to no voids or seams. In embodiments, the trench may have been completely filled (e.g. overfilled) with the interlayer dielectric and the interlayer dielectric (and optionally one or more of the auxiliary layers) may have been subsequently recessed to form the cavity at the top of the trench. Doing so advantageously allows to ensure a good quality of the interlayer dielectric that remains (i.e. the portion under the cavity); e.g. because seams will typically form at the top of the interlayer dielectric and will thus be removed upon recessing said top.

It is was surprisingly realized within the present invention that the advantages of an interlayer dielectric with both good gap fill properties and a low wet-etch ratio (WER), particularly to (dilute) HF, can be combined by protecting the interlayer dielectric with an etch stop layer. In a sense, it can be put forward that the etch stop layer increases the effective WER of the interlayer dielectric; with the understanding that the WER of the interlayer dielectric is not necessarily increased as such, but that increase arises because the etchant is hindered or prevented from contacting the interlayer dielectric. A further advantage is that the height of the interlayer dielectric is maintained, since any variability in the etching conditions (e.g. etching duration) is born by the etch stop layer and not by the interlayer dielectric. As such, the height of the interlayer dielectric can be well controlled, thereby also allowing good control over the final gate height. To ensure achieving all of the above, the etch stop layer preferably has a low WER to HF. In embodiments, the etch stop layer may have a WER compared to thermal oxide of 3 or less, preferably 2 or less, more preferably 1 or less, most preferably 0. Furthermore, the etch stop layer is preferably removable at a later stage of the semiconductor processing; e.g. during a CMP or recessing of the replacement gate after replacement of the dummy gate (cf. infra). Nevertheless, particularly if it is also to be used during dummy gate replacement (cf. infra), the etch stop layer is preferably compatible with (i.e. not unintentionally removed during) the steps leading up to and including said replacement.

In embodiments, the etch stop layer may comprise (e.g. consist of) a high-k dielectric material. In embodiments, the etch stop layer may comprise (e.g. consist of) HfO₂. In embodiments, the etch stop layer may have a thickness of 10 nm or less, preferably 6 nm or less, such as from 2 to 6 nm.

In embodiments, covering the semiconductor structure with the etch stop layer in step b may be conformally covering the semiconductor structure with the etch stop layer. In embodiments, step b may comprise an atomic layer deposition. In embodiments, covering the semiconductor structure with the etch stop layer in step b may completely fill the cavity. The degree to which the cavity is filled in step b typically depends on the thickness of the provided etch stop layer in relation to the size of the cavity.

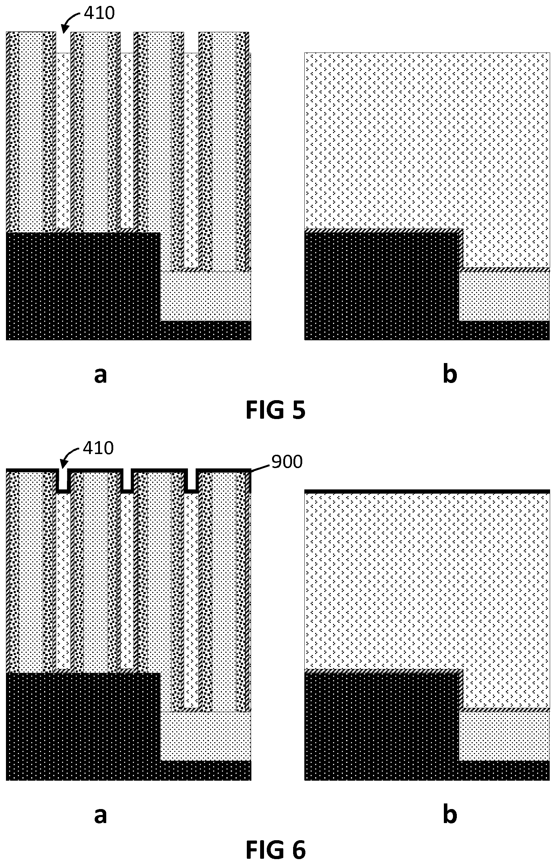

In embodiments, the method may comprise a step b', between steps b and c, of: (b') completely filling the partially filled cavity with a dielectric. In embodiments, step b' may comprise a plasma-enhanced atomic layer deposition or a plasma-enhanced chemical vapour deposition. Providing the dielectric advantageously allows to fill up the cavity, if not yet so, and thus to provide a flat, coplanar top surface for the trench. Furthermore, if the semiconductor structure comprises isolated regions, the etch stop layer is typically more open in those regions (see e.g. FIG 6) and thus more accessible to being unintentionally removed. Here also, the presence of the dielectric (which can be provided simultaneously with filling the cavity) is advantageous, in that it aids in protecting the etch stop layer in those regions from said unintentional removal.

In embodiments, before step b the cavity may cover the interlayer dielectric but not the one or more auxiliary layers. In embodiments, after step c the etch stop layer may cover the interlayer dielectric but not the one or more auxiliary layers. In order to protect the interlayer dielectric during step d, it is typically sufficient for it to cover only the interlayer dielectric, and thus to have the cavity before step b only over the interlayer dielectric. Furthermore, when forming said cavity by recessing (cf. supra), it is advantageously typically easier to recess only the interlayer dielectric.

In embodiments, before step b the cavity may cover the interlayer dielectric and the one or more auxiliary layers. In embodiments, after step c the etch stop layer may cover the interlayer dielectric and the one or more auxiliary layers. If the etch stop layer is also to be used for protection during the gate cutting (cf. infra), then it can be advantageous to have the interlayer dielectric also over the auxiliary layers. For example, this can allow forming, together with the high-k dielectric of the replacement gate (cf. infra), a continuous etch stop layer protecting the structures thereunder; especially when the high-k dielectric and the etch stop layer are made of a same material (e.g. HfO₂).

In embodiments, any feature of any embodiment of the first aspect may independently be as correspondingly described for any embodiment of any of the other aspects.

In a second aspect, the present invention relates to a method for replacing a dummy gate, comprising the method according to any of the previous claims and further comprising: (e) filling an opening, obtained by removing the dummy gate in step d, with a replacement gate.

The replacement gate may in embodiments also be referred to as a 'metal gate' and the method may then likewise be referred to as a 'replacement metal gate process'.

In embodiments, step e may comprise lining the opening with a high-k dielectric, lining the high-k dielectric-lined opening with a work function material, and filling the work function material-lined opening with a fill metal.

In embodiments, the method may further comprise: (f) cutting the replacement gate. In embodiments, cutting the replacement gate may comprise lithographically removing a section of the replacement gate. In embodiments, cutting the replacement gate may be performed selectively with respect to the etch stop layer and, optionally, with respect to the high-k dielectric. It was also surprisingly realized within the present invention that the etch stop layer can also significantly improve the effective etch selectivity with respect to the interlayer dielectric during gate cutting of the replacement gate while keeping a vertically straight profile for the etched replacement gate.

In embodiments, the replacement gate may comprise a high-k dielectric acting as an etch stop liner during step f. This can advantageously allow forming a continuous etch stop layer (cf. supra). In embodiments, the high-k dielectric may comprise (e.g. consist of) a same material as the etch stop layer. In embodiments, the high-k dielectric may comprise (e.g. consist of) HfO₂. The high-k dielectric can advantageously be made of the same material as the etch stop layer. In alternative embodiments, the high-k dielectric may comprise a different material than the etch stop layer. In this case, material of the high-k dielectric is preferably be selected such that it can perform a similar etch stopping function.

In embodiments, the method may further comprise: (g) removing the etch stop layer. In some embodiments, step g may be performed while planarizing the replacement gate or while planarizing a gate cap on top of the replacement gate. In other embodiments, step g may be performed while recessing the replacement gate. Both of these advantageously allow removing the etch stop layer as part of steps which must likely be performed anyway, i.e. without requiring further separate steps specifically dedicated to said removal.

In embodiments, any feature of any embodiment of the second aspect may independently be as correspondingly described for any embodiment of any of the other aspects.

In a third aspect, the present invention relates to a semiconductor structure, comprising: (i) a substrate, (ii) a dummy gate on the substrate, (iii) a trench adjoining the dummy gate by a sidewall, (iv) one or more auxiliary layers lining the sidewall, (v) an interlayer dielectric partially filling the trench such that a cavity at a top of the trench is unfilled, and (vi) an etch stop layer covering at least the interlayer dielectric. Such a semiconductor structure is obtainable after step b of the first aspect (e.g. after step c or after step d) or after step e of the second aspect (e.g. after step f) but before step g.

In embodiments, the etch stop layer may cover the interlayer dielectric and optionally the one or more auxiliary layers, but not the dummy gate. Such a semiconductor structure is obtainable after step c of the first aspect (e.g. after step d) or after step e of the second aspect (e.g. after step f) but before step g.

In embodiments, any feature of any embodiment of the third aspect may independently be as correspondingly described for any embodiment of any of the other aspects.

The invention will now be described by a detailed description of several embodiments of the invention. It is clear that other embodiments of the invention can be configured according to the knowledge of the person skilled in the art without departing from the true technical teaching of the invention, the invention being limited only by the terms of the appended claims.

### Example 1

We now refer to FIG 1. An initial semiconductor structure is provided comprising a Si substrate (100) comprising a fin (110), a shallow trench isolation (STI) oxide (200) isolating for isolating the fin (110), lines of amorphous Si (a-Si) dummy gates (300) over the substrate (100) with trenches (400) therebetween, a Si₃N₄ hard mask material (501) and a SiO₂ hard mask material (502) forming a gate cap (500) over the dummy gates (300) and a gate spacer (600) (e.g. Si₃N₄ or a low-k spacer) lining sidewalls of the dummy gates (300) and gate caps (500) with respect to the trenches (400).

We now refer to FIG 2. A Si₃N₄ liner (700) is conformally deposited over the initial semiconductor structure using a plasma-enhanced atomic layer deposition (PEALD).

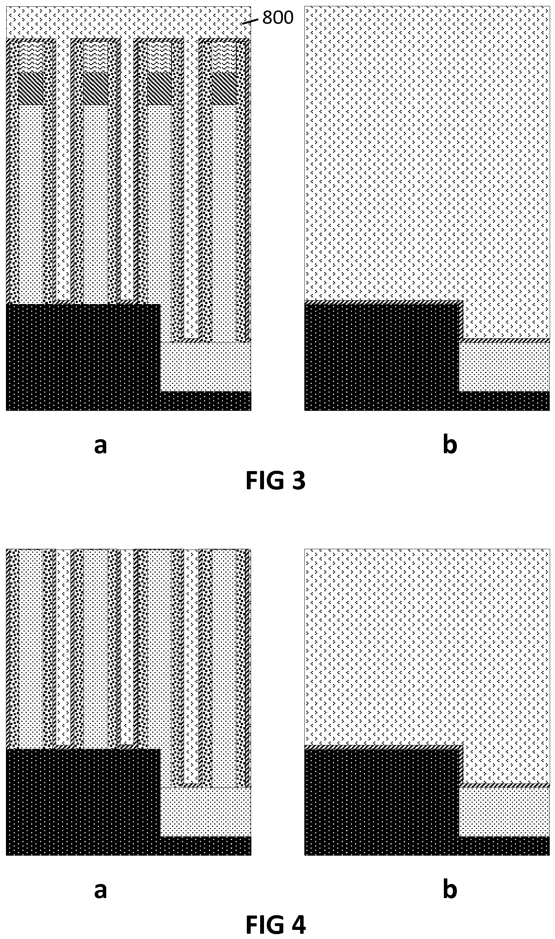

We now refer to FIG 3. The trenches (400), now lined with the liner (700), are overfilled with a SiO₂ ILD0 (0^{th} interlayer dielectric; 800) using a flowable chemical vapour deposition (FCVD) and optionally PEALD.

We now refer to FIG 4. The ILD0 (800) overburden is removed by a chemical-mechanical planarization (CMP), in so doing also removing the gate cap (500).

We now refer to FIG 5. The ILD0 (800) is partially recessed, selectively with respect to the liners (700), gate spacers (600) and dummy gates (300), thereby opening up a cavity (410).

We now refer to FIG 6. A HfO₂ etch stop layer (900) is conformally deposited over the semiconductor structure using atomic layer deposition (ALD). The etch stop layer (900) may be deposited so that it only partially fills the cavity (410) (as depicted), or so that it fills up the entire cavity (410) (not depicted).

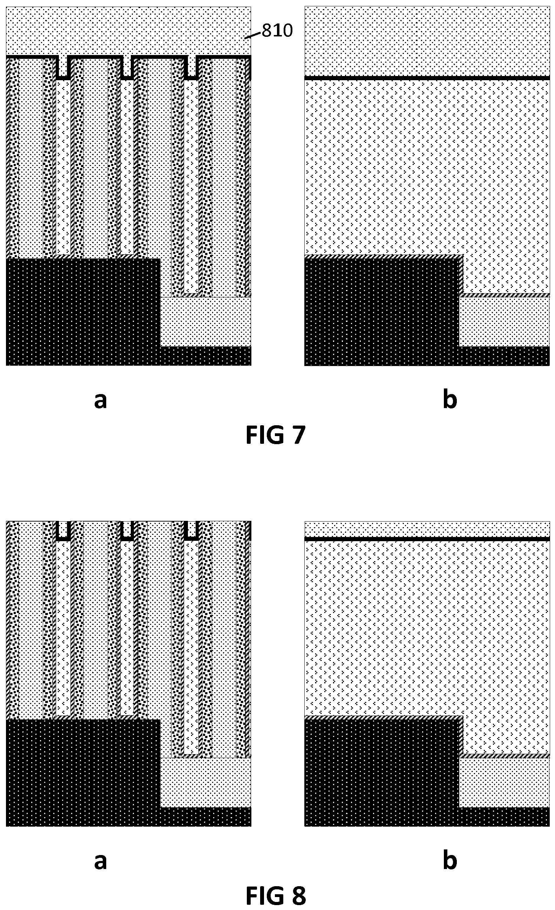

We now refer to FIG 7. The remaining cavity (410) is topped up with a SiO₂ top-up dielectric (810) using PEALD or (plasma-enhanced) chemical vapour deposition ((PE)CVD).

We now refer to FIG 8. A CMP is performed to remove the overburden of top-up dielectric (810) and to remove the etch stop layer (900) over the liners (700), gate spacers (600) and dummy gates (300).

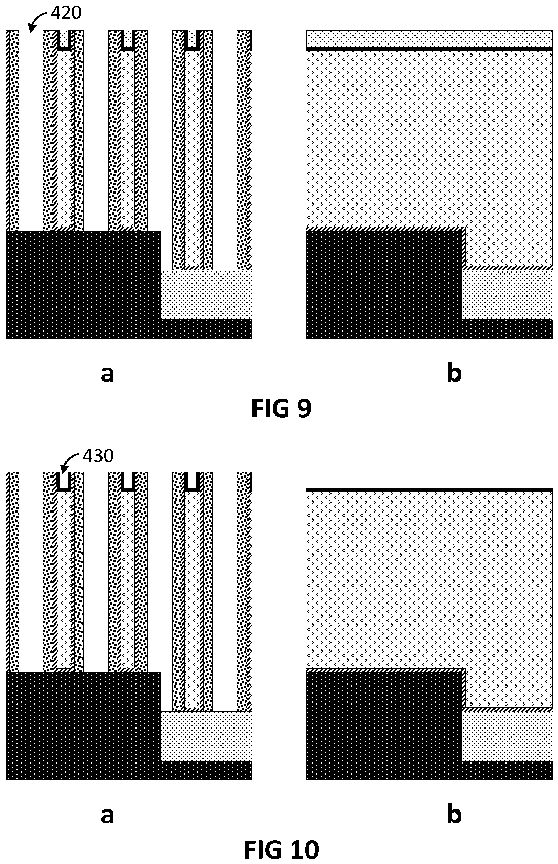

We now refer to FIG 9. The dummy gates (300) are removed, selectively with respect to the gate spacers (600), liners (700), etch stop layer (900) and top-up dielectric (810); leaving openings (420; e.g. trenches).

We now refer to FIG 10. The top-up dielectric (810) is fully or partially removed (430) by the RMG process steps, selectively with respect to the etch stop layer (900), liners (700) and gate spacers (600). The etch stop layer (900) protects the underlying ILD0 (800), thereby maintaining its height.

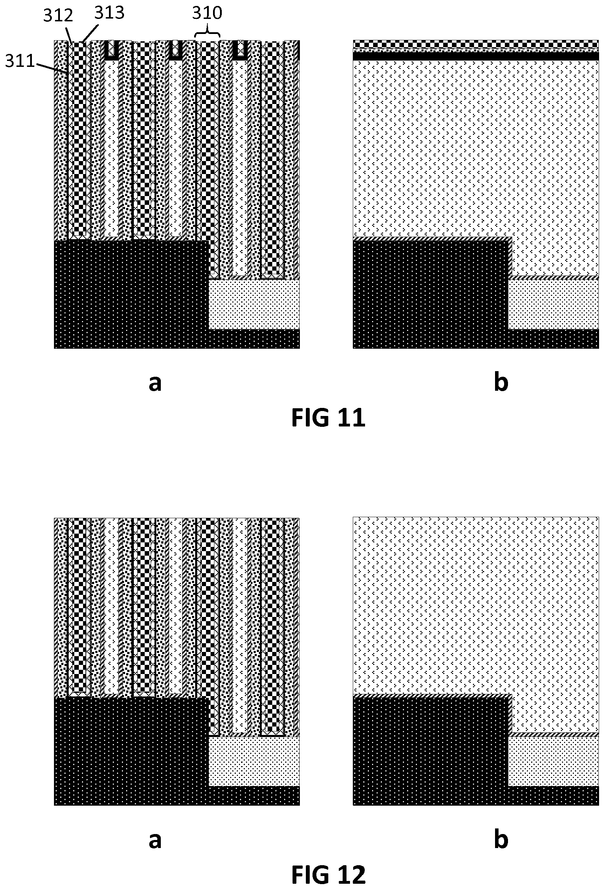

We now refer to FIG 11. A replacement gate (310) is provided by first lining the openings (420) with a high-k dielectric (311; e.g. HfO₂ deposited by ALD), then with a work function material (312) and subsequently filling them up with a fill metal (313; e.g. W). This typically also fills the openings (430) over the etch stop layer (900), e.g. the high-k dielectric (311) and work function material (312) may completely fill these openings (430).

We now refer to FIG 12. A CMP is performed to remove the remaining etch stop layer (900) and to planarize the obtained semiconductor structure.

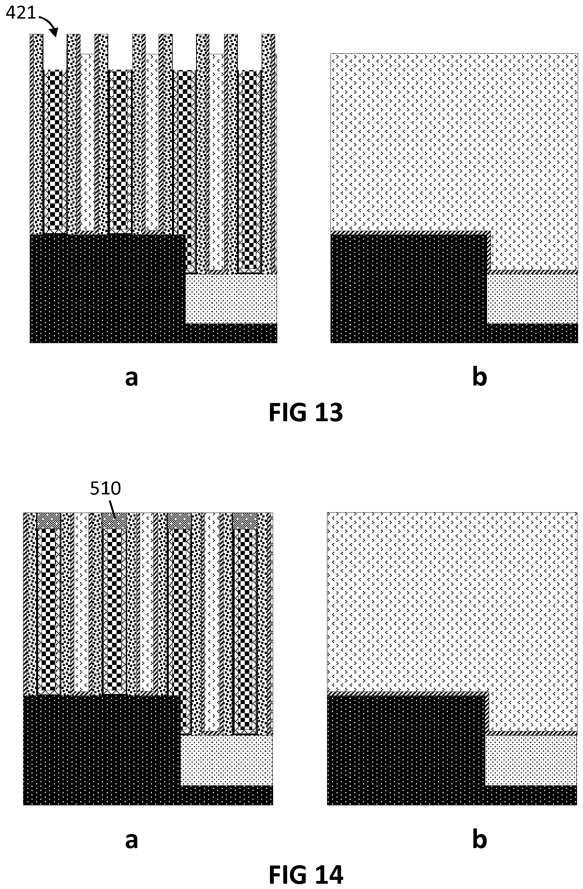

As an alternative to the former step, the replacement gate (310) can also be partially recessed while simultaneously removing the etch stop layer (900) (FIG 13). The recess (421) can then be filled with a Si₃N₄ gate cap (510) and the obtained semiconductor structure can again be planarized by CMP (FIG 14).

### Example 2

The steps relating to FIGS 1-4 of example 1 are repeated.

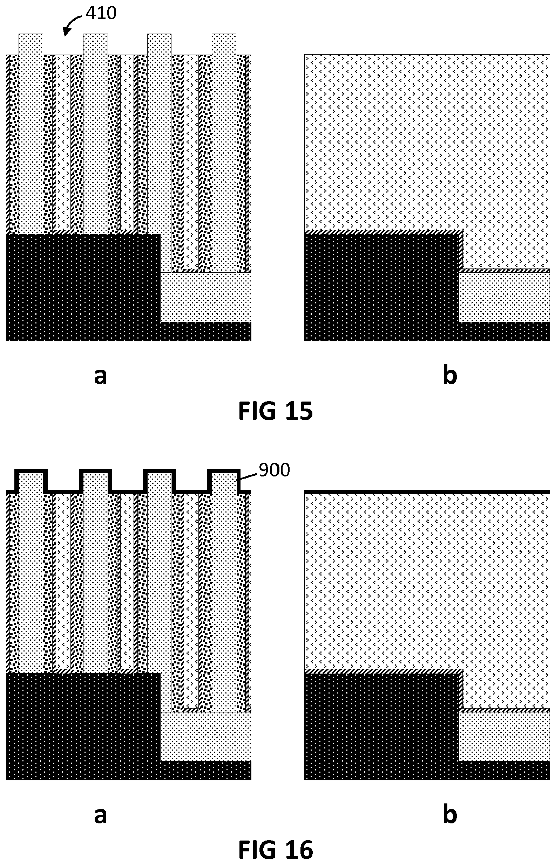

We now refer to FIG 15. The ILD0 (800), liners (700) and gate spacers (600) are partially recessed, selectively with respect to the dummy gates (300), thereby opening up a cavity (410).

We now refer to FIG 16. A HfO₂ etch stop layer (900) is conformally deposited over the semiconductor structure using ALD. The etch stop layer (900) may be deposited so that it only partially fills the cavity (410) (as depicted), or so that it fills up the entire cavity (410) (not depicted).

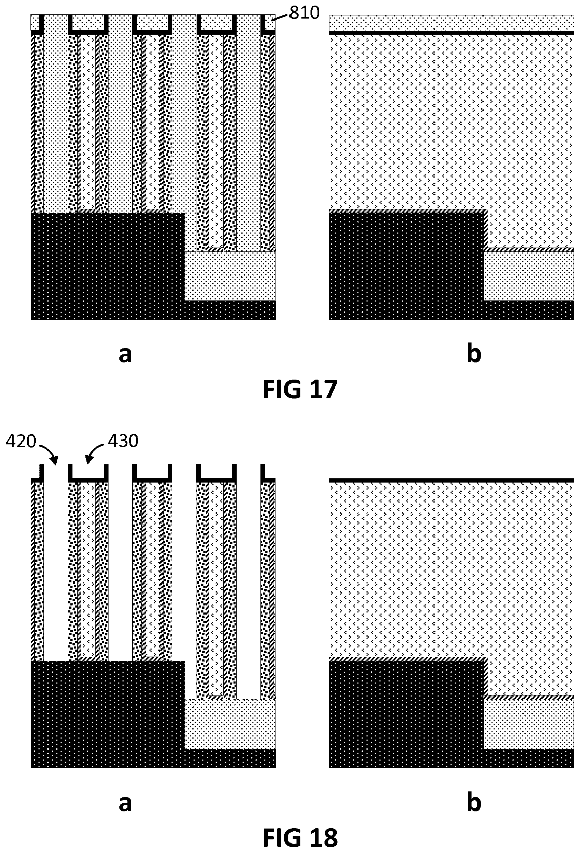

We now refer to FIG 17. The remaining cavity (410) is topped up with a SiO₂ top-up dielectric (810), and a CMP is subsequently performed to remove the overburden of top-up dielectric (810) and to remove the etch stop layer (900) over the dummy gates (300).

We now refer to FIG 18. The dummy gates (300) and top-up dielectric (810) are removed, selectively with respect to the gate spacers (600), gate liner (700) and etch stop layer (900); leaving openings (420 and 430) (e.g. trenches). The etch stop layer (900) protects the underlying ILD0 (800), thereby maintaining its height.

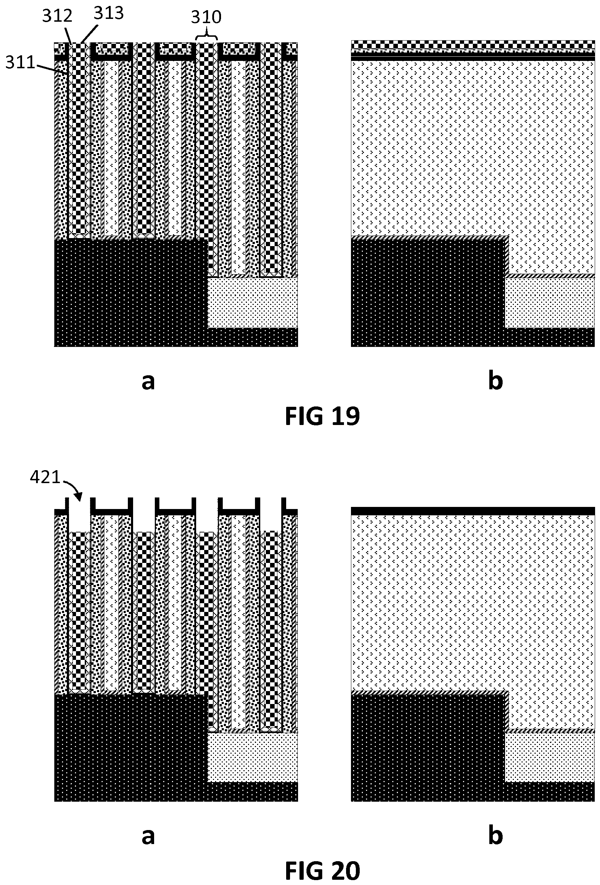

We now refer to FIG 19. A replacement gate (310) is provided by first lining the openings (420) with a high-k dielectric (311) (e.g. HfO₂ deposited by ALD), then with a work function material (312) and subsequently filling them up with a fill metal (313) (e.g. W). This typically also fills the openings (430) over the etch stop layer (900).

We now refer to FIG 20. The fill metal (313) and work function material (312) of the replacement gate (310) are partially recessed (421), selectively with respect to the high-k dielectric (311) and etch stop layer (900). To ensure this selectively, it is advantageous that both the high-k dielectric (311) and etch stop layer (900) are made of the same material (e.g. HfO₂.)

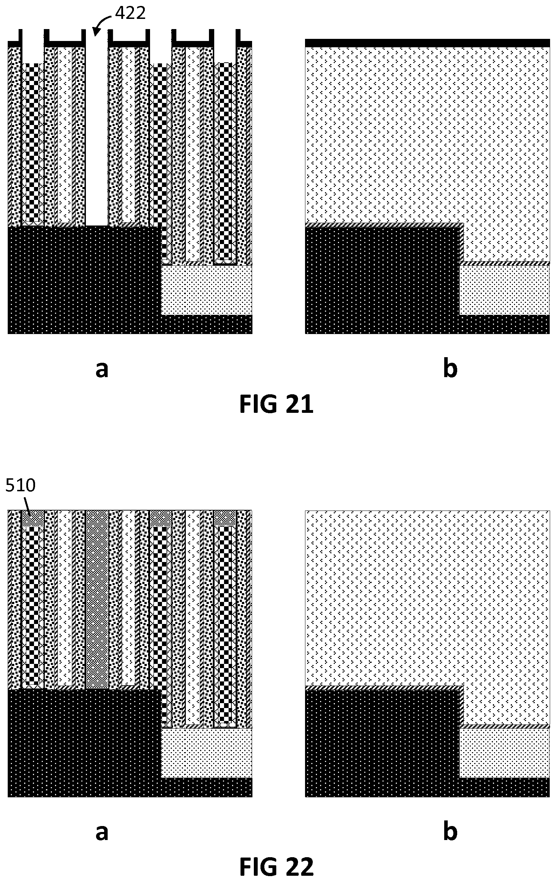

We now refer to FIG 21. The replacement gates (310) are cut (422), again selectively with respect to the high-k dielectric (311) and the etch stop layer (900).

We now refer to FIG 22. The etch stop layer (900) is optionally etched. The cut (422) and recessed (421) replacement gates (310) are filled and capped with Si₃N₄ (510); after which a CMP is performed to remove the remaining etch stop layer (900) and to planarize the obtained semiconductor structure.

It is to be understood that although preferred embodiments, specific constructions and configurations, as well as materials, have been discussed herein for devices according to the present invention, various changes or modifications in form and detail may be made without departing from the scope and technical teachings of this invention. For example, any formulas given above are merely representative of procedures that may be used. Functionality may be added or deleted from the block diagrams and operations may be interchanged among functional blocks. Steps may be added or deleted to methods described within the scope of the present invention.

## Claims

1. A method for removing a dummy gate (300), comprising:
a. providing a semiconductor structure comprising:
i. a substrate (100),
ii. a dummy gate (300) on the substrate (100),
iii. a trench (400) adjoining the dummy gate (300) by a sidewall,
iv. one or more auxiliary layers (600,700) lining the sidewall, and
v. an interlayer dielectric (800) partially filling the trench (400) such that a cavity (410) at a top of the trench (400) is unfilled;
b. covering the semiconductor structure with an etch stop layer (900), thereby at least partially filling the cavity (410);
c. removing the etch stop layer (900) over the dummy gate (300) while maintaining it in the cavity (410), and
d. removing the dummy gate (300) selectively with respect to the etch stop layer (900) and the one or more auxiliary layers (600,700).

2. The method according to claim 1, wherein after step c the etch stop layer (900) covers the interlayer dielectric (800) but not the one or more auxiliary layers (600,700).

3. The method according to claim 1, wherein after step c the etch stop layer (900) covers the interlayer dielectric (800) and the one or more auxiliary layers (600,700).

4. The method according to any of the previous claims, wherein the etch stop layer (900) comprises HfO₂.

5. The method according to any of the previous claims, wherein the one or more auxiliary layers (600,700) comprise a gate spacer (600) and a gate liner (700).

6. The method according to any of the previous claims, comprising a step b', between steps b and c, of:
b'. completely filling the partially filled cavity (410) with a dielectric (810).

7. The method according to claim 6, wherein step b' comprises a plasma-enhanced atomic layer deposition or a plasma-enhanced chemical vapour deposition.

8. A method for replacing a dummy gate (300), comprising the method according to any of the previous claims and further comprising:
e. filling an opening (410), obtained by removing the dummy gate (300) in step d, with a replacement gate (310).

9. The method according to claims 8, wherein step e comprises
- lining the opening (410) with a high-k dielectric (311),
- lining the high-k dielectric-lined opening with a work function material (312), and
- filling the work function material-lined opening (410) with a fill metal (313).

10. The method according to any of claims 8 to 9, further comprising:
f. cutting the replacement gate (310).

11. The method according to claim 10, wherein the replacement gate (310) comprises a high-k dielectric (311) acting as an etch stop liner (700) during step f.

12. The method according to any of claims 8 to 11, further comprising:
g. removing the etch stop layer (900).

13. The method according to claim 12, wherein step g is performed while planarizing or recessing the replacement gate (310).

14. A semiconductor structure, comprising:
i. a substrate (100),
ii. a dummy gate (300) on the substrate (100),
iii. a trench (400) adjoining the dummy gate (300) by a sidewall,
iv. one or more auxiliary layers (600,700) lining the sidewall,
v. an interlayer dielectric (800) partiallyfilling the trench (400) such that a cavity (410) at a top of the trench (400) is unfilled, and
vi. an etch stop layer (900) covering at least the interlayer dielectric (800).

15. The semiconductor structure according to claim 14, wherein the etch stop layer (900) covers the interlayer dielectric (800) and optionally the one or more auxiliary layers (600,700), but not the dummy gate (300).
